Europäisches Patentamt

European Patent Office

Office européen des brevets

(19)

(11) Publication number : **0 330 324 B1**

(12) **EUROPEAN PATENT SPECIFICATION**

(45) Date of publication of patent specification :
07.06.95 Bulletin 95/23

(51) Int. Cl.⁶ : **H01L 39/12, H01L 39/24**

(21) Application number : 89301058.7

(22) Date of filing : 03.02.89

(54) Method of preparing a superconductive oxide material.

(30) Priority : 08.02.88 JP 27120/88

(43) Date of publication of application :
30.08.89 Bulletin 89/35

(45) Publication of the grant of the patent :
07.06.95 Bulletin 95/23

(84) Designated Contracting States :
DE FR GB

(56) References cited :
EP-A- 0 308 892
APPLIED PHYSICS LETTERS, vol. 51, no. 11,
14th September 1987, pages 852-854, American Institute of Physics, New York, US; B. OH
et al.: "Critical current densities and transport
in superconducting YBa2Cu3O7-delta films
made by electron beam coevaporation"
JAPANESE JOURNAL OF APPLIED PHYSICS,
vol. 26, no. 7, July 1987, pages L1248-L1250,
Tokyo, JP; Y. ENOMOTO et al.: "Largely
anisotropic superconducting critical current in
epitaxially grown Ba2YCu3O7-y thin film"
JOURNAL OF THE AMERICAN CERAMIC
SOCIETY, vol. 70, no. 12, December 1987,
pages C388-C390, Columbus, Ohio, US; I.-W.
CHEN et al.: "Texture development in
YBa2Cu3Ox by hot extrusion and hot-pressing"

(56) References cited :
CHEMICAL ENGINEERING NEWS, vol. 266A,
no. 5, 1st February 1988, page 5, Columbus,
Ohio, US; R. DAGANI: "New class of super-
conductors discovered"
JAPANESE JOURNAL OF APPLIED PHYSICS,
vol. 26, no. 12, December 1987, pages
L2080-L2081, Tokyo, JP; J. AKIMITSU et al.:
"Superconductivity in the Bi-Sr-Cu-O system"
Z.Phys.B-Condensed Matter, vol.68, pages
421-423 (1987); C. Michel et al.:
"Superconductivity in the Bi-Sr-Cu-O System"

(73) Proprietor : MATSUSHITA ELECTRIC
INDUSTRIAL CO., LTD.
1006, Oaza Kadoma
Kadoma-shi, Osaka-fu, 571 (JP)

(72) Inventor : Kugimiya, Kouichi
4-16-1-112 Kamisinden
Toyonaka Osaka 565 (JP)
Inventor : Adachi, Seiji
6-7-203 Naritacho
Neyagawa Osaka 572 (JP)
Inventor : Inoue, Osamu
2-134-9-901 Okubocho
Moriguchi Osaka 570 (JP)
Inventor : Kawashima, Syunichiro
38-57 Indacho
Hirakata Osaka 573 (JP)

(74) Representative : Spencer, Graham Easdale et
al
A.A. Thornton & CO
Northumberland House
303-306, High Holborn
London WC1V 7LE (GB)

EP 0 330 324 B1

## Description

This invention relates to a method of preparing an oxide superconductive material as described in the first part of Claim 1.

Recently, as superconductive materials, YBaCu0 system materials have been reported, and various tests and studies are being conducted. As a result, these materials have been disclosed to be very unstable and low in the critical current. Besides, the price is high because rare earth elements are used in quantities, and is susceptible to market fluctuations, and economically unstable elements have been also indicated. It is desired to be improved in all these points.

More recently, new materials of SrBiCu0 system are reported, but details are not known at present.

It is a primary object of this invention to present a material free from the above problems in critical current, stability, and economy.

An article "Texture Development in $YB_2Cu_3O_x$ by Hot Extrusion and Hot-Pressing" by Chen et al (in the December 1987 issue of the Communications of the American Ceramic Society, pages C-388 to C-390) describes various processes for obtaining particular alignments of crystal planes in a $YBa_2Cu_3O_x$ superconductor. Powders of $YBa_2Cu_3O_x$ were hot extruded, with a 3 times reduction in area during the extrusion process, so as to produce a sample with the c-axis of the $YBa_2Cu_3O_x$ crystal structure at random orientation in a plane perpendicular to the extrusion axis.

An article "Superconductivity in the Bi-Sr-Cu-O System" by Michel et al (in Zeitschrift fur Physik B-Condensed Matter 68, 421-423 of 1987) describes a superconductive Bi-Sr-Cu-O compound as having a bidimensional structure. Samples of the compound were prepared by heating mixtures of $Bi_2O_3$ and CuO and $SrCO_3$ in air followed by sintering.

The present invention provides a method of preparing a superconductive material compact comprising the following steps:

producing powder comprising elements A, Bi, Cu and O, where A is at least one alkaline earth metal;

forming the powder into a body; and

sintering the formed body;

characterised in that there is further provided the step of hot-extruding the sintered body using a nozzle with rectangular section.

This material is almost free from erosion by water or the like because probably due to the orientation, oriented C-plane surface prevent the undesirable progress of erosion and it does not contain rare earth elements and alkaline earth elements that cause instability abundantly in an unstable form. In addition, the solid solution range is estimated to be broad, and probably owing to this property, the material is stable by always containing the high temperature superconductor phase. Furthermore, since the C-plane orientation has a specific intraplane Cu chain arrangement, it seems to contribute to the enhancement of critical current. It seems that further excellent characteristics are obtained because a proper element-to-element distance is realized by mixing alkaline earth elements larger than and smaller than 0.1 nm in ion radius.

As a result, the material excels in economy because, as obvious from the summary herein, materials are saved due to the high critical current and it does not contain expensive and unstably supplied rare earth elements at all.

While the novel features of the invention are set forth in the appended claims, the invention, both as to organization and content, will be better understood and appreciated, along with other objects and features thereof, from the following detailed description.

As a result of follow-up tests on general recent YBaCu0 system materials, the transition temperature was about 90°K, according to the investigation by the present inventors, even in the optimum composition of the so-called 123 (the ratio of Y/Ba/Cu). When the composition was slightly varied, an impurity phase was generated, and the characteristics fluctuated. This material was fabricated into a wire by hot extrusion at 950°C, and the critical current was measured at 50°K. This value is called reference value 1 of this invention.

By contrast, according to the investigation of the present inventors, the new material possesses stable and excellent characteristics as follows.

Oxides containing at least one type each from a group of Mg, Ca of which ion radius is 0.1 nm or less, and a group of Sr, Ba, and also Bi and Cu were weighed so that the ratio of the three A/Bi/Cu might be nearly 5/3/5, 3/2/3, 2/1/2 or in their vicinity, and were uniformly mixed, and temporarily baked at 800 to 850°C, crushed, formed and sintered at 830 to 870°C. The material was extruded at 800°C. A nozzle with a rectangular section having an axial ratio of 5/1 was used. According to experiments carried out by the inventors, although the higher ratios had yielded better results in general, the ratio of 3/1 or over results in a high C-plane orientation as observed radiographically. In the X-ray diffraction diagram, the rate of (00n) intensity of the total of the oriented oxide superconductive materials is approximately over 80%.

The obtained results are shown in Table 1.

## Table 1

|  | Composition | | | | | | Transition temperature | Current ratio | Phase |
|---|---|---|---|---|---|---|---|---|---|
|  | Sr | Ca | Ba | Mg | Bi | Cu | | | |
| 1 | 3.3 | 1.7 | 0 | 0 | 3 | 5 | 105 | 3 | Single |
| 2 | 3.8 | 2.2 | 0 | 0 | 4 | 5 | 108 | 4 | Single |
| 3 | 3.5 | 2.5 | 0 | 0 | 4 | 5 | 110 | 6 | Single |
| 4 | 4.5 | 1.5 | 0 | 0 | 5 | 4 | 113 | 2 | Single |
| 5 | 3.0 | 3.0 | 0 | 0 | 3 | 5 | 102 | 5 | Single |
| 6 | 0.5 | 0.5 | 0 | 0 | 1 | 1 | 82 | 1 | Plural |
| 7 | 1.5 | 1.5 | 0 | 0 | 2 | 2 | 81 | 2 | Plural |
| 8 | 1.0 | 1.0 | 0 | 0 | 1 | 2 | 101 | 9 | Plural |
| 9 | 2.0 | 2.0 | 0 | 0 | 2 | 3 | 84 | 2 | Plural |
| 10 | 2.0 | 2.0 | 1 | 1 | 4 | 5 | 106 | 4 | Single |
| 11 | 2.0 | 2.0 | 1 |  | 3 | 5 | 101 | 4 | Single |
| 12 | 4.0 | 0.5 | 1 | 0.5 | 4 | 5 | 110 | 8 | Single |
| 13 | 2.0 | 1.0 | 0.5 | 0.5 | 2 | 3 | 101 | 8 | Plural |
| 14 | 2.0 |  | 2 |  | 2 | 3 | 23 | 0 | Plural |
| 15 | 1.5 | 1.5 |  |  | 2 | 3 | 105 | 4 | Single |
| 21 | 0.5 | 0.5 | 0 | 0 | 0.2 | 1 | 103 | 4 | Single |
| 22 | 0.5 | 0.5 | 0 | 0 | 1/3 | 1 | 101 | 4 | Single |
| 23 | 0.5 | 1.0 | 0 | 0 | 0.2 | 1 | 110 | 9 | Single |
| 24 | 0.5 | 1.0 | 0 | 0 | 1/3 | 1 | 106 | 3 | Single |
| 25 | 0.5 | 1.0 | 0 | 0 | 1/4 | 1 | 113 | 7 | Single |
| 26 | 0.5 | 0.5 | 0 | 0 | 1 | 1 | 82 | 2 | Plural |
| 27 | 1.5 | 1.5 | 0 | 0 | 2 | 1 | 81 | 1 | Plural |
| 28 | 1.0 | 1.0 | 0 | 0 | 1 | 1 | 101 | 6 | Plural |
| 29 | 2.0 | 2.0 | 0 | 0 | 2 | 1 | 84 | 2 | Plural |
| 30 | 0.5 | 0.5 | 0.2 | 0.2 | 0.3 | 1 | 105 | 7 | Single |
| 31 | 0.3 | 0.6 | 0.2 | 0.1 | 0.3 | 1 | 101 | 2 | Single |
| 32 | 0.2 | 0.9 | 0.1 |  | 1/4 | 1 | 102 | 6 | Single |
| 33 | 2.0 | 1.0 | 0.5 | 0.5 | 2 | 1 | 101 | 3 | Plural |
| 34 | 0.4 | 0.9 |  |  | 1/4 | 1 | 113 | 7 | Single |

As obvious from the table, the transition temperature was stable in all examples. Moreover, by mixing the elements of the two groups, the transition temperature was over 80°K as compared with 20 to 30°K in the case of single group composition. In the humidity resistance test of leaving at high temperature and high humidity (60°, 60%) for a month, the so-called YBaCu system materials were whitened on the whole and were considerably decayed, the new materials were only slightly whitened on the surface and were very stable. As known from Table 1, in spite of single phase and plural phases, basically, the ratio of the critical current to the reference value was remarkably improved in all materials (except for material 14), and excellent characteristics were found.

As the X-ray analysis results show, a crystal phase in a composition ratio in the vicinity of the single 3/2/3 or 5/3/5 is formed in a considerably wide range (it is estimated, as being presently investigated, to be composed of superlattice of pseudotetragonal system with unit cell of 0.54 nm, considering together with the results of transmission electron microscopic findings, as being nominally expressed as orthorhombic system with the lattice constants of a = 0.54 nm, b = 0.54 x 5 = 2.7 nm and c = 1.53 x 2 = 3.06 nm), and it is known that it is very easy to cleave on C-plane.

It is assumed that high orientation of more than 80% is due to the cleaving characteristics of the materials. Therefore, this technology of extension can be applied to other oxide superconducting materials which shows clear cleaving characteristics.

According to the invention, materials excelling in humidity resistance, broad in the solid solution range, large in critical current, and superior in safety and reproducibility may be presented, which may be widely applied in superconductive appliances.

While specific embodiments of the invention have been illustrated and described herein, it is realized that other modifications and changes will occur to those skilled in the art. It is therefore to be understood that the present invention includes all modifications and changes which fall within the scope of the appended claims.

**Claims**

1. A method of preparing a superconductive material compact comprising the following steps:
producing powder comprising elements A, Bi, Cu and 0, where A is at least one alkaline earth metal;
forming the powder into a body; and
sintering the formed body;
characterised in that there is further provided the step of hot-extruding the sintered body using a nozzle with rectangular section.

2. A method according to claim 1, wherein the axial ratio of the nozzle is 3 or more.

3. A method according to claim 1 or 2, wherein A is a mixture of at least two alkaline earth metals.

4. A method according to claim 3, wherein the mixture is composed of at least one of Mg and Ca and at least one of Sr and Ba.

**Patentansprüche**

1. Ein Verfahren zum Herstellen eines supraleitfähigen Materialpreßkörpers, umfassend die folgenden Schritte:
Herstellen eines Pulvers, umfassend die Elemente A, Bi, Cu und 0, wobei A wenigstens ein Erdalkalimetall ist;
Formen des Pulvers in einen Körper; und
Sintern des Formlings;
dadurch charakterisiert, daß der weitere Schritt vorgesehen ist, den Sinterkörper unter Verwendung einer Düse mit einem rechtwinkligen Querschnitt heiß zu extrudieren.

2. Ein Verfahren 1, wobei das axiale Verhältnis der Düse 3 oder mehr beträgt.

3. Ein Verfahren nach Anspruch 1 oder 2, wobei A eine Mischung von wenigstens zwei Erdalkalimetallen ist.

4. Ein Verfahren nach Anspruch 3, wobei die Mischung aus wenigstens einem von Mg und Ca und wenigstens einem von Sr und Ba zusammengesetzt ist.

**Revendications**

1. Procédé de préparation d'un corps compacté de matériau supraconducteur, comprenant les opérations suivantes :

produire une poudre qui comprend les éléments A, Bi, Cu et O, où A représente au moins un métal alcalino-terreux ;

former la poudre en un corps ; et

fritter le corps ainsi formé ;

caractérisé en ce qu'il est en outre prévu l'opération consistant à extruder à chaud le corps fritté à l'aide d'une filière à section rectangulaire.

2. Procédé selon la revendication 1, où le rapport dimensionnel de la filière est de 3 ou plus.

3. Procédé selon la renvendication 1 ou 2, où A est un mélange d'au moins deux métaux alcalino-terreux.

4. Procédé selon la revendication 3, où le mélange est constitué d'au moins une substance choisie parmi Mg et Ca et d'au moins une substance choisie parmi Sr et Ba.